(19) Europäisches Patentamt
European Patent Office
Office européen des brevets

(11) EP 3 978 549 A1

(12) **EUROPEAN PATENT APPLICATION**
published in accordance with Art. 153(4) EPC

(43) Date of publication:
**06.04.2022 Bulletin 2022/14**

(21) Application number: **20817747.7**

(22) Date of filing: **27.05.2020**

(51) International Patent Classification (IPC):
***C08G 73/12*** *(2006.01)* ***G03F 7/027*** *(2006.01)*
***G03F 7/20*** *(2006.01)*

(52) Cooperative Patent Classification (CPC):
**C08G 73/12; G03F 7/027; G03F 7/20**

(86) International application number:
**PCT/JP2020/021023**

(87) International publication number:
**WO 2020/246349 (10.12.2020 Gazette 2020/50)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **03.06.2019 JP 2019103475**

(71) Applicant: **MITSUBISHI GAS CHEMICAL COMPANY, INC.**
**Chiyoda-ku**
**Tokyo 100-8324 (JP)**

(72) Inventors:
- **SATO, Yumi**
  **Kurashiki-shi, Okayama 712-8525 (JP)**
- **KUMANO, Tatsuyuki**
  **Kurashiki-shi, Okayama 712-8525 (JP)**
- **UTAMURA, Tatsuya**
  **Kurashiki-shi, Okayama 712-8525 (JP)**
- **MIYAHARA, Daichi**
  **Kurashiki-shi, Okayama 712-8525 (JP)**

(74) Representative: **Hoffmann Eitle**
**Patent- und Rechtsanwälte PartmbB**
**Arabellastraße 30**
**81925 München (DE)**

(54) **PHOTOSENSITIVE RESIN COMPOSITION AND CURED FILM THEREOF**

(57) A photosensitive resin composition including a polyimide resin (A) having a specific structure and a weight average molecular weight of 70000 or less is provided.

EP 3 978 549 A1

## Description

### Technical Field

The present invention relates to a photosensitive resin composition and a cured film of the photosensitive resin composition.

### Background Art

Polyimide resins having excellent heat resistance and insulating properties are widely used in surface protection films, interlayer insulating films, wiring protection insulating films for circuit boards and the like of electronic devices. From the perspective of an increase in the density and the degree of integration of semiconductor integrated circuits in recent years, insulating materials for semiconductor integrated circuits are required to have a better characteristics in pattern development compared to a related art, as well as various physical properties such as high insulation, improved heat resistance, low temperature curability, crack resistance, and flexibility. When a difference in solubility between an exposed portion and an unexposed portion is greater, the characteristics in the pattern development is better. In order to improve the development characteristics, it is important to increase the difference in solubility between the exposed portion and the unexposed portion. Furthermore, in order to express a desired physical properties, it is also necessary to appropriately select a raw material of a base polymer and to perform the polymer design accordingly.

Because polyimide has low solvent solubility, a method for introducing a polymerizable group into a polyimide precursor has been proposed as a method for producing photosensitive polyimide. Patent Document 1 proposes a method for introducing a polymerizable group into a side chain of a polyimide precursor. Patent Document 2 proposes a method for introducing a polymerizable group at a terminal end of a polyimide precursor.

Alternatively, a method of introducing a polymerizable group into a solvent-soluble polyimide has been proposed. Polyimide having a polymerizable group in a side chain has been proposed because polymerizable groups can be introduced at a high density. Patent Document 3 proposes a method for providing a polymerizable group on a side chain of a polyimide.

### Citation List

#### Patent Documents

Patent Document 1: JP 2013-76845 A
Patent Document 2: WO 2018/003725
Patent Document 3: JP 2000-147761 A

### Summary of Invention

#### Technical Problem

In the methods disclosed in Patent Documents 1 and 2, the polyimide precursor needs to be heated at a high temperature for a long period of time in order to form polyimide, and they are not suitable for an application in which low temperature curing is required. In addition, a volume shrinkage of about 50% occurs including a shrinkage during a heating step to form polyimide precursor. There is a problem that this may cause warpage and cracks.

In the method disclosed in Patent Document 3, a functional group for providing a polymerizable group is required to be introduced into the side chain of the polyimide. This limits the choice of the raw material options for the polyimide synthesis. Furthermore, in the method of providing the polymerizable group in the side chain, curability may be good because the polymerizable group can be introduced at a high density, but there is a problem that the curing shrinkage rate is large and cracks are likely to occur.

In view of the above circumstances, it is an object of the present invention to provide a photosensitive resin composition which does not require a heating step, has excellent characteristics in development, provides a wider degree of freedom in selecting a polyimide raw material, and has low curing shrinkage.

#### Solution to Problem

As a result of diligent studies, the present inventors have found that a photosensitive resin composition containing

a polyimide resin having a specific structure and a specific terminal end structure and having a specific weight average molecular weight solves the problems described above.

The present invention relates to the following photosensitive resin composition and a cured film of the photosensitive resin composition.

[1] A photosensitive resin composition including a polyimide resin (A) having a structure represented by General Formula (1) below and having a weight average molecular weight of 70000 or less,

[Chem. 1]

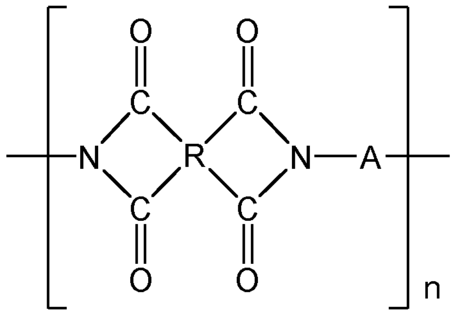

(1)

where R is a tetravalent group having 4 to 10 carbons and having a cyclic structure, an acyclic structure, or a cyclic structure and an acyclic structure, A has at least one group selected from the group consisting of an aliphatic hydrocarbon group, cycloaliphatic hydrocarbon group, aromatic hydrocarbon group, and organosiloxane group, and is a divalent group having from 2 to 39 carbons, on a main chain of A, at least one intervening group selected from the group consisting of -O-,$-SO_2-$,-CO-,$-CH_2-$,$-C(CH_3)_2-$,$-C_2H_4O-$, and -S- may be present, n indicates the number of repeating units, a terminal end of the general formula (1) is either a group represented by Formula (2) or Formula (3) below, or a hydrogen atom, and at least one of the terminal ends is a group represented by Formula (2) or Formula (3), and

[Chem. 2]

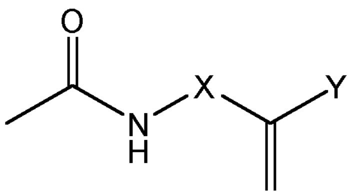

(2)

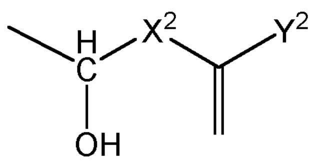

(3)

where X and $X^2$ are each independently a group having from 2 to 15 carbons and may have at least one group selected from the group consisting of ester bonds and double bonds, and Y and $Y^2$ are each independently a hydrogen atom or a methyl group.

[2] The photosensitive resin composition according to [1], wherein a weight average molecular weight of the polyimide resin (A) is 5000 or greater.

[3] The photosensitive resin composition according to [1] or [2], wherein a light transmittance at a wavelength from 200 to 400 nm of the polyimide resin (A) is 50% or greater.

[4] The photosensitive resin composition according to any one of [1] to [3], wherein a residual film ratio of an unexposed portion after exposure under a condition of a dose from 1500 to 2500 m $J/cm^2$ at a wavelength of 365 nm is 40% or less.

[5] The photosensitive resin composition according to at least one of [1] to [4], wherein A in General Formula (1) contains an aromatic ring as an aromatic hydrocarbon group.

[6] The photosensitive resin composition according to any one of [1] to [5], wherein A in General Formula (1) includes at least one type selected from the group consisting of the structures shown below,

[Chem. 3]

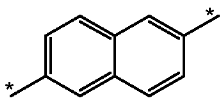
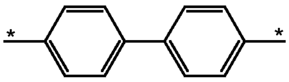
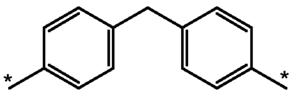
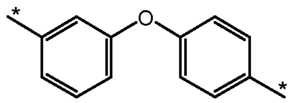
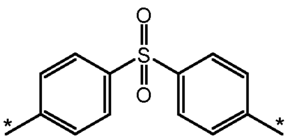
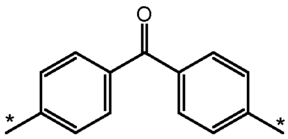
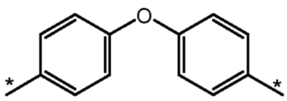
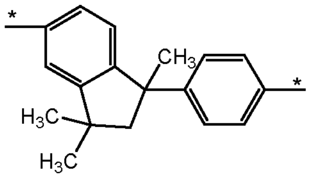
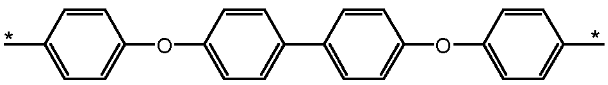
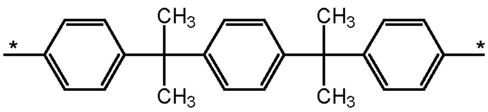
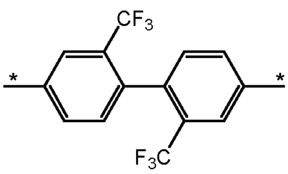
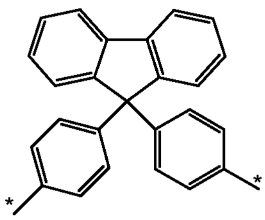
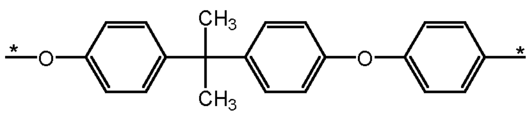
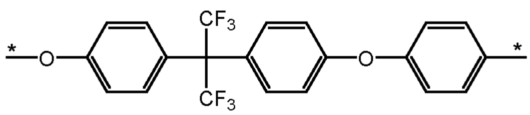
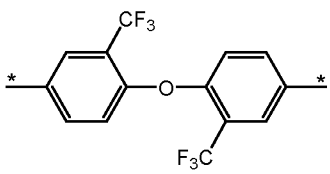
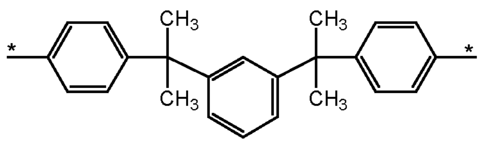

where * indicates an atomic bond.

[7] The photosensitive resin composition according to any one of [1] to [6], in which the polyimide resin (A) includes at least one type of units constituted of 4,4'-diamino-2,2'-bis(trifluoromethyl)biphenyl, 1-(4-aminophenyl)-2,3-dihydro-1,3,3-trimethyl-1H-indene-5-amine, 4,4'-oxybis[3-(trifluoromethyl)benzenamine] or 1,3-bis[2-(4-aminophenyl)-2-propyl]benzene.

[8] The photosensitive resin composition according to any one of [1] to [7], further comprising at least one selected from the group consisting of a photopolymerization initiator, a solvent, and a photopolymerizable compound.

[9] The photosensitive resin composition according to [8], wherein the photopolymerizable compound is a polyfunctional radical polymerizable monomer.

[10] The photosensitive resin composition according to any one of [1] to [9], further comprising a sensitizer.

[11] The photosensitive resin composition according to any one of [1] to [10], wherein the photosensitive resin composition is used for forming an insulating film.

[12] A cured film formed by curing the photosensitive resin composition according to any one of [1] to [11].

[13] The cured film according to [12], wherein a thickness of the film is from 10 to 85 μm.

## Advantageous Effects of Invention

According to the present invention, it is possible to obtain a photosensitive resin composition which does not require a heating step, has excellent characteristics in development due to high transparency and excellent solvent solubility and provides a wider degree of freedom in selecting a polyimide raw material. Because the resin composition has a low curing shrinkage, occurrence of cracking or the like in the formed cured film can be effectively suppressed.

Description of Embodiments

Hereinafter, embodiments for carrying out the present invention (hereinafter, referred to simply as "the present embodiment") will be described in detail. The following embodiments are examples for explaining the present invention, and do not limit the contents of the present invention. The present invention can be modified as appropriate within the scope of the gist. In the present specification, the preferred stipulations can be optionally employed, and combinations of the preferred ones are considered more preferable. In the present specification, "from XX to YY" describes "XX or more and YY or less".
The term "(meth)acrylate" means both "acrylate" and "methacrylate". The same applies to other similar terms ("(meth)acrylic acid", "(meth)acryloyl group", etc.).

[Polyimide resin (A)]

The polyimide resin (A) of the present embodiment has a structure represented by general formula (1) below and has a weight average molecular weight of 70000 or less.

[Chem. 4]

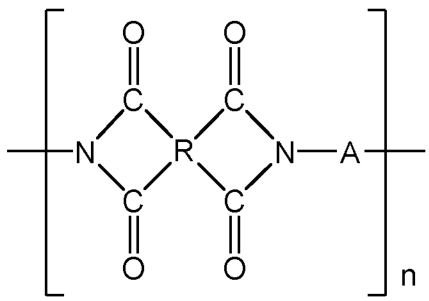

(1)

where R is a tetravalent group having from 4 to 10 carbons and having a cyclic structure, an acyclic structure, or a cyclic structure and an acyclic structure, A is a divalent group having from 2 to 39 carbons and having at least one group selected from the group consisting of an aliphatic hydrocarbon group, an alicyclic hydrocarbon group, an aromatic hydrocarbon group, and an organosiloxane group, there may be at least one intervening group selected from the group consisting of $-O-$,$-SO_2-$,$-CO-$,$-CH_2-$,$-C(CH_3)_2-$,$-C_2H_4O-$, and $-S-$ on a main chain of A, n indicates the number of repeating units, a terminal end of the general formula (1) is either a group represented by Formula (2) or Formula (3) below, or a hydrogen atom, and at least one of the terminal ends is a group represented by Formula (2) or Formula (3), and

[Chem. 5]

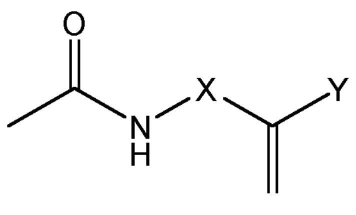

(2)

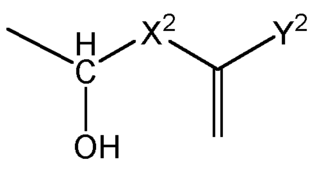

(3)

where X and $X^2$ are each independently a group having 2 to 15 carbons and may have at least one group selected from the group consisting of ester bonds and double bonds, and Y and $Y^2$ are each independently a hydrogen atom or a methyl group.
R in Formula (1) above preferably has at least a cyclic structure, and examples of the cyclic structure include tetravalent groups formed by excluding four hydrogen atoms from cyclohexane, cyclopentane, cyclobutane, bicyclopentane and these stereoisomers. More specifically, examples of the tetravalent group include a group represented by the

following structural formula.

[Chem. 6]

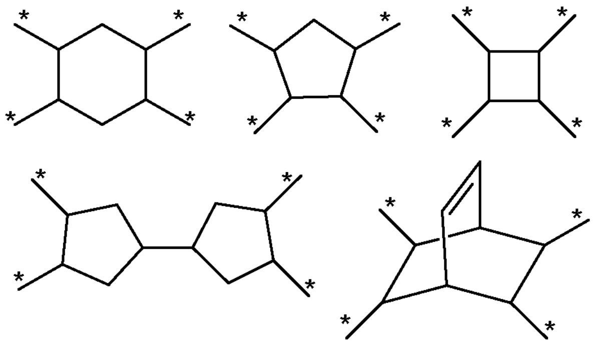

where * indicates an atomic bond.

Of these, a tetravalent group formed by excluding four hydrogen atoms from cyclohexane is more preferable.

In Formula (1), A is a divalent group having 2 to 39 carbons and having at least one group selected from the group consisting of an aliphatic hydrocarbon group, an alicyclic hydrocarbon group, an aromatic hydrocarbon group, and an organosiloxane group. There may be at least one intervening group selected from the group consisting of -O-,$-SO_2-$,-CO-, $-CH_2-$,$-C(CH_3)_2-$,$-C_2H_4O-$, and -S- on a main chain of A.

More specifically, A includes a divalent group formed by removing two hydrogen atoms from a compound such as cyclohexane, dicyclohexylmethane, dimethylcyclohexane, isophorone, norbornane and alkyl substitutes thereof and halogen substitutes; benzene, naphthalene, biphenyl, diphenylmethane, diphenyl ether, diphenylsulfone, benzophenone and alkyl substitutes and halogen substitutes thereof; and organo(poly)siloxanes. Preferably, A has a cyclic structure and preferably A has an alicyclic hydrocarbon group and/or an aromatic ring. Preferably, A has an aromatic ring as an aromatic hydrocarbon group. More specifically, a divalent group having 6 to 27 carbons represented by the following structural formula is preferable.

[Chem. 7]

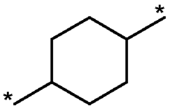 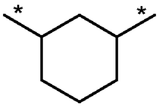 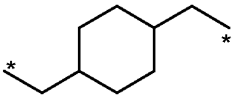 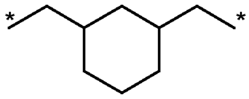

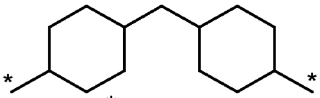 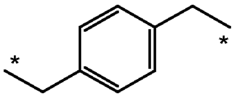 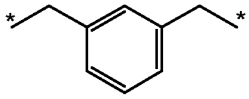

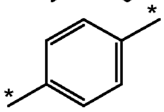 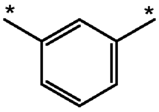 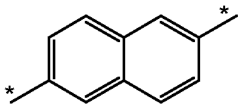 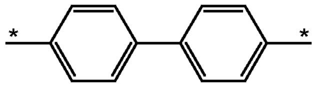

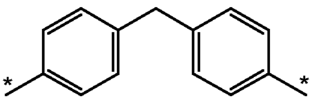 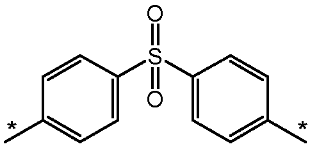 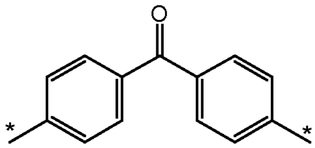

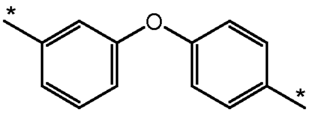 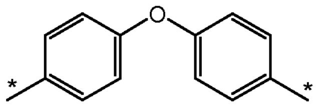 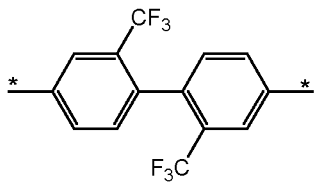

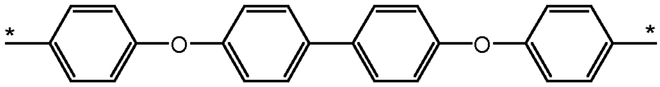

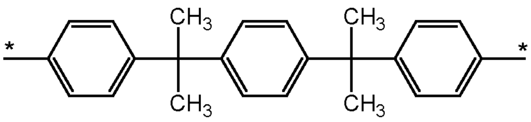 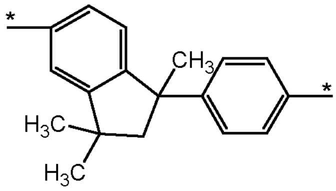

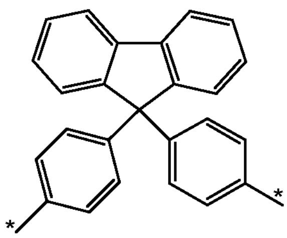 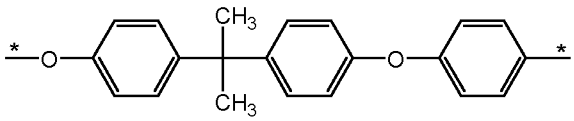 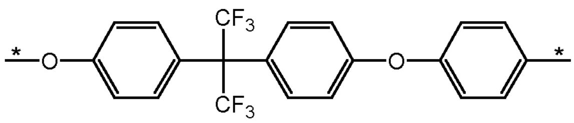

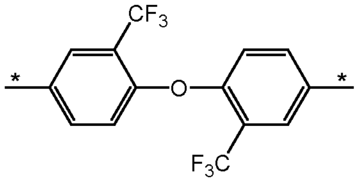 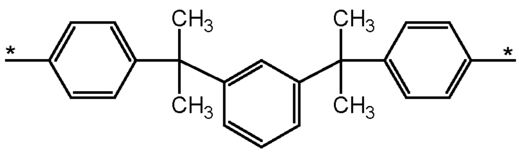

where * indicates an atomic bond.

More preferably, the group corresponding to A exemplified above is preferably at least one type selected from the group consisting of the structures shown below.

[Chem. 8]

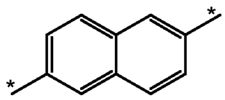
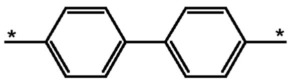
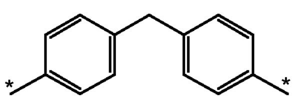
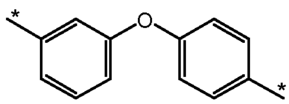
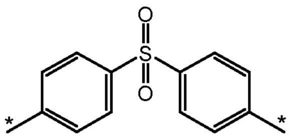
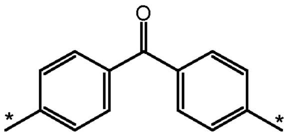
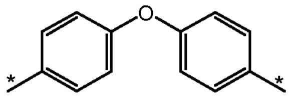
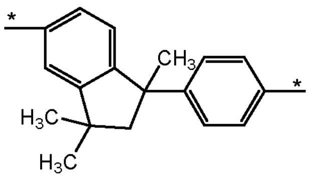
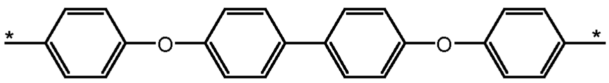
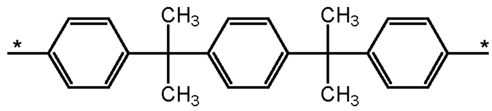
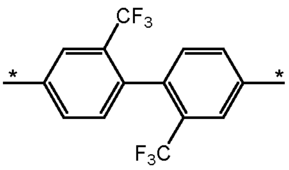
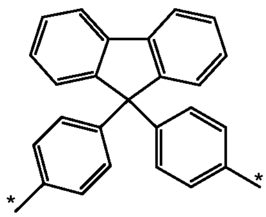
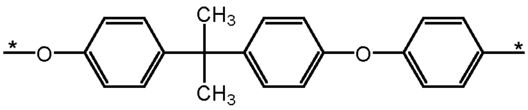
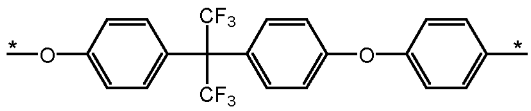
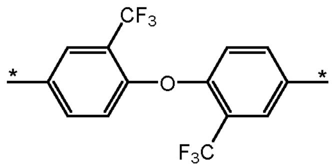
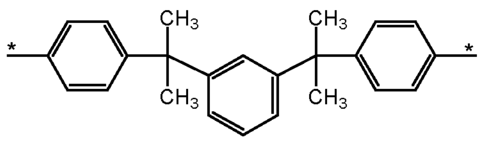

where * indicates an atomic bond.

n which indicates the number of repeating units of the structural unit represented by the formula (1) is preferably from 5 to 250, more preferably from 10 to 200, and further preferably from 15 to 150. When n is 15 or more, a cured film has desired mechanical properties. When n is 250 or less, sufficient solvent solubility can be ensured.

The polyimide resin (A) of the present embodiment has either the group represented by the general formula (2) or the general formula (3), or a hydrogen atom at a terminal end, and at least one of the terminal ends is a group represented by the general formula (2) or the general formula (3). The polyimide resin (A) may have a structure represented by general formula (2) or general formula (3) on one terminal end, or may have a structure represented by the general formula (2) or the general formula (3) on both terminal ends.

The group represented by X or $X^2$ in general formula (2) or general formula (3) is a group having from 2 to 15 carbons and may have at least one group selected from the group consisting of ester bonds and double bonds. The group represented by Y or $Y^2$ is a hydrogen atom or a methyl group.

More specifically, the structure represented by the general formula (2) or the general formula (3) corresponds to a structure formed by reacting a terminal diamine of the polyimide resin (A) with a functional group-containing compound. Examples of the functional group-containing compound include compounds having an isocyanate group or an epoxy group and a (meth)acryl group. Examples of the compound include 2-isocyanatoethyl methacrylate, 2-isocyanatoethyl acrylate, 1,1-bis(acryloyloxymethyl)ethyl isocyanate, glycidyl methacrylate, glycidyl acrylate, and allyl glycidyl ether. The structure represented by general formula (2) or general formula (3) may have a structure formed by reacting the compound and the amine terminal.

It is required that the polyimide resin (A) has a weight average molecular weight of 70000 or less. When the weight average molecular weight exceeds 70000, the solvent solubility of the resin composition decreases, which is not suitable for forming a cured film. The weight average molecular weight is preferably 60000 or less, more preferably 50000 or less, more preferably 45000 or less, even more preferably 40000 or less, even more preferably 35000 or less, even more preferably 30000 or less, and particularly preferably less than 30000. Since a cured film having desired mechanical properties can be formed, the weight average molecular weight of the polyimide resin (A) is preferably 5000 or greater. The weight average molecular weight of the polyimide resin (A) is more preferably 10000 or greater, more preferably 13000 or greater, and even more preferably 15000 or greater. When the weight average molecular weight of the polyimide resin (A) is within the range described above, a residual film ratio of the unexposed portion is low, and a resin composition having excellent characteristics in development can be obtained.

The polyimide resin (A) can be formed by reacting the diamine component and the tetracarboxylic acid component described in detail below.

<Diamine component>

Examples of the diamine component include diamine, diisocyanate and diaminodisilane, and diamine is preferable. The diamine content in the diamine component used as a raw material is preferably 50 mol% or greater and may be 100 mol%.

The diamine may be any of an aliphatic diamine and an aromatic diamine and may be a mixture thereof. In the present invention, "aromatic diamine" refers to a diamine in which an amino group is directly bonded to an aromatic ring and "aromatic diamine" may include aliphatic groups, alicyclic groups, and other substituent groups in part of the structure. "Aliphatic diamine" refers to a diamine in which an amino group is directly bonded to an aliphatic group or an alicyclic group, and "aliphatic diamine" may include an aromatic group or other substituent groups in part of the structure.

In general, when an aliphatic diamine is used as a raw material of a polyimide resin, a polyamide acid which is an intermediate product and the aliphatic diamine form a strong complex, making it difficult to produce a high-molecular weight polyimide. Therefore, improvements such as the use of a solvent in which the complex has a relatively high solubility, such as using cresols or the like, is required. When cyclohexanetetracarboxylic acid, cyclobutanetetracarboxylic acid, or derivative thereof is used as the tetracarboxylic acid component, a complex having a relatively weak bond between the polyamic acid and the aliphatic diamine is formed. Thus, the molecular weight of the polyimide can be easily increased. When a diamine having a fluorine substituent is selected as a raw material, transparency of the produced polyimide resin is excellent, which is preferable.

Any of the aliphatic diamines can be used. Examples of aliphatic diamines include 4,4'-diaminodicyclohexylmethane, ethylenediamine, hexamethylenediamine, polyethyleneglycol bis(3-aminopropyl)ether, polypropyleneglycol bis(3-aminopropyl)ether, 1,3-bis(aminomethyl)cyclohexane, 1,4-bis(aminomethy1 )cyclohexane, m-xylylenediamine, p-xylylenediamine, isophorone diamine, norbornane diamine, and siloxane diamines.

Examples of the aromatic diamines include, for example, 4,4'-diaminodiphenyl ether, 4,4'-diaminodiphenylmethane, 4,4'-diaminodiphenyl sulfone, m-phenylenediamine, p-phenylenediamine, diaminobenzophenone, 2,6-diaminonaphthalene, 1,5-diaminonaphthalene, 4,4'-diamino-2,2'-bis(trifluoromethyl)biphenyl, 4,4'-oxybis[3-(trifluoromethyl)benzenamine], 1-(4-aminophenyl)-2,3-dihydro-1,3,3-trimethyl-1H-inden-5-amine and 1,3 -bi s[2-(4-aminophenyl)-2-propyl]benzene.

The diamine preferably contains at least 4,4'-diamino-2,2'-bis(trifluoromethyl)biphenyl, 4,4'-oxybis[3-(trifluoromethyl)benzenamine], 1-(4-aminophenyl)-2,3-dihydro-1,3,3-trimethyl-1H-inden-5-amine or 1,3-bis[2-(4-aminophenyl)-2-propyl]benzene. When any one of them above is included as a diamine component, the photosensitive resin composition containing the polyimide resin (A) has high light transmittance at a specific wavelength and high solvent solubility. As a result, the photosensitive resin composition exhibits excellent curability of the exposed portion, the low residual film ratio of the unexposed portion, and excellent characteristics in development. Any of the above may be included as the diamine component, and excellent effects may be maintained even when other diamines are used in combination. The polyimide resin (A) of the present embodiment preferably contains at least one unit constituted of 4,4'-diamino-2,2'-bis(trifluoromethyl)biphenyl, 1-(4-aminophenyl)-2,3-dihydro-1,3,3-trimethyl-1H-inden-5-amine, 4,4'-oxybis[3-(trifluoromethyl)benzenamine] or 1,3-bis[2-(4-aminophenyl)-2-propyl]benzene.

<Tetracarboxylic acid component>

Any of the tetracarboxylic acid components can be used. Examples of the tetracarboxylic acid component include cyclohexanetetracarboxylic acid, cyclohexanetetracarboxylic esters, cyclohexanetetracarboxylic dianhydride, cyclobutanetetracarboxylic acid, cyclobutanetetracarboxylic esters, cyclobutanetetracarboxylic dianhydride, cyclopentanetetracarboxylic acid, cyclopentanetetracarboxylic esters, cyclopentanetetracarboxylic dianhydrides, bicyclopentanetetracarboxylic dianhydrides. Of these, cyclohexanetetracarboxylic dianhydride, cyclobutanetetracarboxylic dianhydride, and cyclopentanetetracarboxylic dianhydride are more preferable. Among the above, cyclohexanetetracarboxylic dianhydride is more preferable. The various tetracarboxylic acid components described above include a positional isomer.

More preferred specific examples of the tetracarboxylic acid component described above include 1,2,4,5-cyclohexanetetracarboxylic acid, 1,2,4,5-cyclohexanetetracarboxylic dianhydride, 1,2,4,5-cyclohexanetetracarboxylic acid methyl ester, 1,2,3 4-butanetetracarboxylic acid, 1,2,3,4-butanetetracarboxylic dianhydride, 1,2,3,4-butanetetracarboxylic acid methyl ester, 1,2,3,4-cyclobutanetetracarboxylic acid, 1,2,3,4-cyclobutanetetracarboxylic dianhydride, 1,2,3 4-cyclobutanetetracarboxylic acid methyl ester, 1,2,4,5-cyclopentanetetracarboxylic acid, 1,2,4,5-cyclopentanetetracarboxylic dianhydride, 1,2,4,5-cyclopentanetetracarboxylic acid methyl ester, 3-carboxymethyl-1,2,4-cyclopentanetricarboxylic acid, bicyclo[2.2.2] octa-7-ene-2,3,5,6-tetracarboxylic acid, bicyclo[2.2.2] octa-7-ene-2,3,5,6-tetracarboxylic acid dianhydride, bicyclo[2.2.2] octa-7-ene-2,3,5,6-tetracarboxylic acid methyl ester, dicyclohexyltetracarboxylic acid, dicyclohexyltetracarboxylic dianhydride, dicyclohexyltetracarboxylic acid methyl ester.

Among these, 1,2,4,5-cyclohexanetetracarboxylic acid, 1,2,4,5-cyclohexanetetracarboxylic dianhydride, 1,2,3,4-cyclobutanetetracarboxylic dianhydride, and 1,2,4,5-cyclohexanetetracarboxylic acid methyl ester are particularly preferable because they facilitate increase in the molecular weight in production of the polyimide resin and they are advantageous in production of a flexible film.

The tetracarboxylic acid component may include other tetracarboxylic acid or a derivative thereof in a range that does not impair the flexibility and thermocompression bonding property of the resulting cured film, for example, the film. Examples of these other tetracarboxylic acids or derivatives thereof include at least one selected from: pyromellitic acid, 3,3',4,4'-biphenyltetracarboxylic acid, 2,3,3',4'-biphenyltetracarboxylic acid, 2,2-bis(3,4-dicarboxyphenyl)propane, 2,2-bis(2,3-dicarboxyphenyl)propane, 2,2-bis(3,4-dicarboxypheny1)-1,1, 1,3,3,3-hexafluoropropane, 2,2-bis(2,3-dicarboxyphenyl)-1,1,1,3,3,3-hexafluoropropane, bis(3,4-dicarboxyphenyl)sulfone, bis(3,4-dicarboxyphenyl)ether, bis(2,3-dicarboxyphenyl)ether, 3,3',4,4'-benzophenone tetracarboxylic acid, 2,2',3,3'-benzophenone tetracarboxylic acid, 4,4-(p-phenylenedioxy)diphthalic acid, 4,4-(m-phenylenedioxy)diphthalic acid, ethylenetetracarboxylic acid, 1,1-bis(2,3-dicarboxyphenyl)ethane, bis(2,3-dicarboxyphenyl)methane, bis(3,4-dicarboxyphenyl)methane and derivatives thereof.

<Method for producing polyimide resin>

The polyimide resin (A) included in the photosensitive resin composition of the present embodiment can be obtained by the following steps (1) and (2):

Step (1): a tetracarboxylic acid component and a diamine component are reacted to form a polyimide resin having an amino group in its terminal end.

Step (2): the polyimide resin having an amino group at the terminal end produced in step (1), the functional group-containing compound (a compound having an isocyanate group or an epoxy group and a (meth)acryl group) are reacted.

<Step (1)>

The tetracarboxylic acid and diamine component described above are reacted to form a polyimide resin having an amino group at a terminal end.

An organic solvent used when the tetracarboxylic acid component and the diamine component are reacted is not particularly limited, but an organic solvent containing at least one type selected from the group consisting of cyclic ethers, cyclic ketones, cyclic esters, amides and ureas is preferable. Specific examples of suitable solvents include, but are not limited to, at least one type selected from the group consisting of aprotic polar organic solvents such as γ-butyrolactone, N,N-dimethylacetamide, N,N-dimethylformamide, N-methyl-2-pyrrolidone, dimethyl sulfoxide, hexamethylphosphoramide, cyclopentanone, cyclohexanone, 1,3-dioxolane, 1,4-dioxane, tetramethylurea and tetrahydrofuran. Among these, the solvent may be preferably one or more types selected from the group consisting of γ-butyrolactone, N,N-dimethylacetamide, N,N-dimethylformamide, and N-methyl-2-pyrrolidone.

When the tetracarboxylic acid component and the diamine component are reacted in step (1), an imidization catalyst can be used. As the imidization catalyst, a tertiary amine compound is preferable, and specifically, at least one selected from the group consisting of trimethylamine, triethylamine (TEA), tripropylamine, tributylamine, triethanolamine, N,N-dimethylethanolamine, N,N-diethylethanolamine, triethylenediamine, N-methylpyrrolidine, N-ethylpyrrolidine, N-methylpiperidine, N-ethylpiperidine, imidazole, pyridine, quinoline and isoquinoline can be used.

The reaction temperature in step (1) is typically in the range from 160 to 200°C, preferably in the range from 170 to 190°C, and more preferably in the range from 180 to 190°C. If the temperature is 160°C or higher, imidization and increase in the molecular weight are sufficiently advanced. If the temperature is 200°C or lower, the solution viscosity can be appropriately maintained, and problems such as caking of the resin on the wall of the reaction vessel can be avoided. In some cases, azeotropic dehydrating agents such as toluene and xylene may be used. The reaction pressure is usually normal pressure, but if necessary, the reaction can be carried out under pressure. The retention time of the reaction temperature is preferably at least 1 hour or longer, and more preferably 3 hours or longer. If the reaction retention time is 1 hour or longer, imidization and polymerization can be sufficiently advanced. The upper limit of the reaction time is not particularly limited, but is normally performed in the range from 3 to 10 hours.

In step (1), when A mol of the tetracarboxylic acid component and B mol of the diamine component are reacted, the reaction is preferably in the range of $0.80 \leq A/B \leq 0.99$, and more preferably in the range of $0.85 \leq A/B \leq 0.95$. When $A/B \leq 0.99$, the terminal end of the polyimide can be made into a diamine in excess, a polyimide resin having an amino group at a terminal end can be obtained, and a polyimide resin having a molecular weight which satisfies sufficient solvent solubility can be obtained. When $0.80 \leq A/B$, a polyimide resin having a molecular weight that realizes sufficient flexibility can be obtained.

As the ratio A/B approaches 1.0, a polyimide resin having a high molecular weight can be formed. Therefore, when the ratio A/B is adjusted appropriately, a polyimide resin having a target molecular weight can be formed.

<Step (2)>

Step (2) is a step of modifying the terminal end of the polyimide resin formed in step (1). Specifically, as described above, the polyimide and the functional group-containing compound described above (a compound having an isocyanate group or epoxy group and a (meth)acryl group) is reacted to produce a polyimide resin having a (meth)acryl group at the terminal end.

The functional group-containing compound that modifies the terminal end of the polyimide resin is a compound having an isocyanate group or an epoxy group and a (meth)acryl group. Specific examples include 2-isocyanatoethyl methacrylate, 2-isocyanatoethyl acrylate, 1,1-bis(acryloyloxymethyl)ethyl isocyanate, glycidyl methacrylate, and allyl glycidyl ether. These functional group-containing compounds may be used alone or in combination of two or more. The functional group-containing compound is preferably used at a ratio from 0.1 to 30 molar ratio with respect to a solid content in a solution containing a polyimide resin having a (meth)acryl group at a terminal end.

The reaction temperature in step (2) is preferably in the range from 30 to 100°C, and the reaction time is preferably from 1 to 5 hours.

When the amino group terminal of the polyimide resin is reacted with the isocyanate group or epoxy group of the functional-group-containing compound, the reaction may be carried out as-is or, if necessary, in the presence of a catalyst. Examples of the catalyst include amine compounds such as triethylamine, organic phosphorus compounds such as triphenylphosphine, and the like, and these may be used alone, or a combination of two or more types may be used. A polymerization inhibitor may be used to suppress side reactions during the reaction. Examples of polymerization inhibitors include hydroquinone, hydroquinone monomethylether, and methylhydroquinone, and these may be used alone, or a combination of two or more types may be used.

The polyimide resin (A) included in the photosensitive resin composition of the present embodiment preferably has a light transmittance at a wavelength from 200 to 400 nm of 50% or greater, more preferably 55% or greater, even more preferably 60% or greater, and even more preferably 70% or greater.

The polyimide resin (A) included in the photosensitive resin composition of the present embodiment has high light transmittance at the wavelength described above, and has excellent solvent solubility. As a result, the photopolymerization initiator that can be included in the composition functions effectively, and thus the cured film can be efficiently produced. In addition, the polyimide resin (A) having a specific structure and a specific terminal structure and having a specific molecular weight is used, and thus, when a cured film is formed from the composition described below, the residual film ratio of the unexposed portion is low, excellent characteristics in development are achieved, and the occurrence of cracks and the like can be effectively suppressed.

[Photosensitive polyimide resin composition]

The photosensitive polyimide resin composition according to the present embodiment includes a polyimide resin (A) having the structure of General Formula (1) and the terminal structure represented by General Formula (2). In addition to the polyimide resin (A), the photosensitive polyimide preferably includes at least one type selected from the group consisting of, for example, photopolymerization initiators, solvents, and photopolymerizable compounds. It is also preferable to further include a sensitizer.

Examples of the solvent include N-methyl-2-pyrrolidone, N-acetyl-2-pyrrolidone, N-benzyl-2-pyrrolidone, N,N-dimethylformamide, N,N-dimethylacetamide, dimethyl sulfoxide, hexamethylphosphortriamide, N-acetyl-ε-caprolactam, dimethylimidazolidinone, diethylene glycol dimethyl ether, triethylene glycol dimethyl ether, and γ-butyrolactone. These solvents may be used alone or in combination of two or more.

The use of an appropriate solvent facilitates use of the photosensitive resin composition of the present embodiment in a solution (varnish) state, and making it convenient for film formation.

As the photopolymerizable compound, a polyfunctional radical polymerizable monomer, for example, a bifunctional or higher (meth)acrylic monomer can be used.

Examples of (meth)acrylic monomer includes tricyclodecanedimethanol diacrylate, tricyclodecanedimethanol dimethacrylate, polypropylene glycol diacrylate, trimethylolpropane triacrylate, trimethylolpropane trimethacrylate, pentaerythritol tetraacrylate, pentaerythritol triacrylate, tris-(2-acryloxyethyl)isocyanurate, ditrimethylolpropane tetraacrylate, and dipentaerythritol hexaacrylate. These photopolymerizable compounds may be used alone or in combination of two or more.

The flexibility and heat resistance of the polyimide resin composition can be controlled by a structure of the photopolymerizable compound to be blended. The photopolymerizable compound is preferably blended at a proportion from 5 to 500 parts by mass with respect to a solid content in the solution containing a polyimide resin having a (meth)acryl group at the terminal end.

The photopolymerization initiator is not particularly limited, and a known photopolymerization initiator can be used. Examples thereof include 2,2-dimethoxy-1,2-diphenylethan-1-one, 1-hydroxycyclohexylphenyl ketone, 2-hydroxy-2-methyl-1-phenylpropane-1-one, 1-[4-(2-hydroxyethoxy)-phenyl]-2-hydroxy-2-methyl-1-propan-1-one, 2-hydroxy-1-{4-[4-(2-hydroxy-2-methyl-propionyl)-benzyl] phenyl}-2-methyl-propan-1-one, 2-methyl-1-(4-methylthiophenyl)-2-morpholinopropane-1-one, 2-benzyl-2-dimethylamino-1-(4-morpholinophenyl)-butanone-1,2-(dimethylamino)-2-[(4-methylphenyl)methyl]-1-[4-(4-morpholinyl)phenyl]-1-butanone, 2,4,6-trimethylbenzoyl-diphenylphosphine oxide and bis(2,4,6-trimethylbenzoyl)phenylphosphine oxide.

The photopolymerization initiator may be used alone or in combination of two or more.

The photopolymerization initiator is preferably mixed at a proportion from 0.1 to 10 parts by mass with respect to a solid content in a solution containing a polyimide resin (A) having a (meth)acryl group at a terminal end.

The sensitizer is not particularly limited, and a known sensitizer can be used. Examples include an amino group-containing sensitizer, and preferably a compound having an amino group and a phenyl group in the same molecule. More specifically, examples thereof include benzophenone-based compounds such as 4,4'-dimethylaminobenzophenone, 4,4'-diethylaminobenzophenone, 2-aminobenzophenone, 4-aminobenzophenone, 4,4'-diaminobenzophenone, 3,3'-diaminobenzophenone, 3,4-diaminobenzophenone; p-dialkylaminophenyl group-containing compounds such as 2-(p-dimethylaminophenyl)benzoxazole, 2-(p-diethylaminophenyl)benzoxazole, 2-(p-dimethylaminophenyl)benzo[4,5]benzoxazole, 2-(p-dimethylaminophenyl)benzo[6,7]benzoxazole, 2,5-bis(p-diethylaminophenyl)-1,3,4-oxadiazole, 2-(p-dimethylaminophenyl)benzothiazole, 2-(p-diethylaminophenyl)benzothiazole, 2-(p-dimethylaminophenyl)benzimidazole, 2-(p-diethylaminophenyl)benzimidazole, 2,5-bis(p-diethylaminophenyl)-1,3,4-thiadiazole, (p-dimethylaminophenyl)pyridine, (p-diethylaminophenyl)pyridine, (p-dimethylaminophenyl)quinoline, (p-diethylaminophenyl)quinoline, (p-dimethylaminophenyl)pyrimidine, and (p-diethylaminophenyl)pyrimidine.

These sensitizers may be used alone or in combination of two or more.

The sensitizer is preferably mixed at a proportion from 0.001 to 10 parts by mass with respect to the solid content in the solution containing the polyimide resin (A) having a (meth)acryl group at the terminal end.

The photosensitive resin composition of the present embodiment is not particularly limited, but can be prepared as follows.

A polyimide resin (A) having a structure represented by the general formula (1) and having a terminal structure represented by the general formula (2) or (3) is mixed, as necessary, at least one type selected from the group consisting of a solvent, a photopolymerization initiator, a photopolymerizable compound and a sensitizer, to form a photosensitive polyimide composition.

The photosensitive resin composition of the present embodiment is particularly preferably used for forming an insulating film.

[Cured Film]

To produce the cured film according to the present embodiment, a solution containing the polyimide resin (A) having the structural characteristics described above is applied on the substrate.

The method of application on the substrate is not particularly limited, and specific examples include ink jet methods, spin coating methods, casting methods, microgravure methods, gravure coating methods, bar coating methods, roll coating methods, wire bar coating methods, dip coating methods, spray coating methods, screen printing methods, flexographic printing methods, and die coating methods.

When the solution is applied on the base material, the solid content concentration of the solution containing the polyimide resin (A) of the present embodiment is preferably adjusted so as to be in a range from 5 to 50 mass%. The solvent used during application is preferably an aprotic polar solvent from the perspective of solubility. Specifically, suitable examples include N-methyl-2-pyrrolidone, N-acety1-2-pyrrolidone, N-benzy1-2-pyrrolidone, N,N-dimethylformamide, N,N-dimethylacetamide, dimethyl sulfoxide, hexamethylphosphortriamide, N-acetyl-ε-caprolactam, dimethylimidazolidinone, diethylene glycol dimethyl ether, triethylene glycol dimethyl ether, and γ-butyrolactone. These solvents may be used alone or in combination of two or more. To further improve the applicability, solvents such as toluene, xylene, diethyl ketone, methoxybenzene, cyclopentanone, and the like may be mixed in a range that does not adversely affect the solubility of the polymer.

Examples of the substrate include glass, silicon wafer, metal foil, and plastic film. Among the substrates above, a silicon wafer and copper foil are preferably used.

The photosensitive resin composition of the present embodiment applied on the substrate is irradiated with light (typically using ultraviolet light) via a prescribed photomask with a predetermined pattern. After irradiation, an unexposed portion is dissolved and removed by a developer to obtain a desired relief pattern.

A dose of ultraviolet radiation is preferably from 500 to 8000 $mJ/cm^2$.

In the method for forming a resin pattern using the photosensitive resin composition of the present embodiment, an organic solvent is preferably used as the developer. The developer is not particularly limited as long as it dissolves the photosensitive resin composition according to the present embodiment. Specifically, suitable examples include N-methyl-2-pyrrolidone, N-acetyl-2-pyrrolidone, N-benzyl-2-pyrrolidone, N,N-dimethylformamide, N,N-dimethylacetamide,

dimethyl sulfoxide, hexamethylphosphortriamide, N-acetyl-ε-caprolactam, dimethylimidazolidinone, diethylene glycol dimethyl ether, triethylene glycol dimethyl ether, and γ-butyrolactone.

These developers may be used alone or in combination of two or more.

The relief pattern formed by the development is then washed with a rinse solution to remove the developing solvent. Suitable examples of the rinse solution include methanol, ethanol, isopropyl alcohol, and water, that are miscible with the developer.

The relief pattern obtained by the process described above can be heated at a temperature selected from a range from 80 to 250°C, the solvent is dried, and a cured film formed by curing the photosensitive resin composition of the present embodiment can be obtained. According to this embodiment, the obtained relief pattern can be formed at a high resolution, because the resin composition is used that has excellent characteristics in development, that is, the exposed portion is sufficiently cured and the unexposed portion is sufficiently removed.

In the cured film formed by curing the photosensitive resin composition according to the present embodiment, the unexposed portion residual film ratio after exposure under conditions of a dose from 1500 to 2500 $mJ/cm^2$ at a wavelength of 365 nm is preferably 45% or less, more preferably 40% or less, even more preferably 30% or less, and even more preferably 10% or less. The light source for exposure is not particularly limited, but, for example, a high-pressure mercury lamp can be used, and the film is exposed at the dose described above at 365 nm.

"Unexposed portion residual film ratio" herein refers to a value calculated from the following definitions. Details of the measurement method are described in the Examples.

Unexposed portion residual film ratio (%)= [mass of unexposed portion after development/mass of unexposed portion before development] × 100

In the cured film formed by curing the photosensitive resin composition according to the present embodiment, the exposed portion residual film ratio is preferably 70% or greater, more preferably 80% or greater, and even more preferably 85% or greater.

Herein, the "exposed portion residual film ratio" is a value calculated from the following definitions. Details of the measurement method are detailed in the Examples.

Exposed portion residual film ratio (%)= [mass of exposed portion after development/mass of exposed portion prior to development] × 100

A thickness of the cured film obtained by the present embodiment is preferably from 10 to 85 μm. When the film thickness is within the range described above, it can be used as an excellent insulating film. When the film thickness is thicker (i.e., the amount of the photosensitive resin composition applied to the base material increases), the solvent solubility of the polyimide resin often becomes particularly problematic. However, according to the present invention, the polyimide resin having a specific structure and a specific terminal structure and having a specific molecular weight range is used, and thus excellent solvent solubility properties and transparency can be achieved in such a case.

Therefore, the cured film of the present embodiment can be suitably used in, for example, an insulating film application where the application of high voltage is assumed. The cured film formed from the photosensitive resin composition of the present embodiment including the polyimide resin (A) having a specific structure and a specific terminal structure and having a specific molecular weight can effectively suppress the occurrence of cracks and the like, and has excellent physical properties.

[Applications]

The photosensitive resin composition and the cured film of the present embodiment can be used in various applications. For example, the photosensitive resin composition can be suitably used in surface-protecting films for semiconductor elements of electronic devices, interlayer insulating films, wiring protection insulating films for circuit boards, and in particular, it can be suitably used for the above-mentioned applications with high density and high integration.

Examples

The present invention will be described in further detail hereinafter using examples and comparative examples, but the present invention is not limited to the following examples.

The evaluation methods employed in the examples and comparative examples are as follows.

(1) Weight average molecular weight and number average molecular weight

The weight average molecular weight (Mw) and number average molecular weight (Mn) were determined by GPC analysis. The equipment used for the analysis and the analysis conditions were as follows.

Equipment: Viscotek TDAmax (available from Malvern Panalytical Ltd.)
Column: A6000M x 2 (available from Malvern Panalytical Ltd.)
Eluent: 20 mM Lithium bromide added dimethylformamide
Flow rate: 1.0 ml/min
Column temperature: 40°C
Detector: RI (refractive index detector), RALS (light scatter detector), LALS (light scatter detector)

(2) Residual film ratio (%) of unexposed portion

A varnish including a photosensitive resin composition including polyimide resin was prepared in the examples and comparative examples described below. The varnish prepared in each of the examples and comparative examples was applied to a silicon wafer using a spin coater, and then heated for 60 minutes at 100°C to remove the solvent. The mass of the varnish at this point (when the solvent was removed under the conditions described above) was defined as the mass of the unexposed portion before development. After the coating was immersed in the developer of γ-butyrolactone for 5 minutes, the coating was washed using methanol as a rinse solution, and the solvent was removed under air flow until the mass did not change any more. The mass of the film remaining on the silicon wafer after removal of the solvent was defined as the mass of the unexposed portion after development, and the unexposed portion residual film ratio was determined by the following formula.

$$\text{Unexposed portion residual film ratio (\%)} = [\text{mass of unexposed portion after development/mass of unexposed portion before development}] \times 100$$

(3) Residual film ratio (%) of exposed portion

A varnish including a photosensitive resin composition including polyimide resin was prepared in the examples and comparative examples described below. The varnish prepared in each of the examples and comparative examples was applied to a silicon wafer using a spin coater, and then heated for 60 minutes at 100°C to remove the solvent. The mass of the varnish at this point (when the solvent was removed under the conditions described above) was defined as the mass of the exposed portion before development. After the coating was irradiated with UV and immersed in the developer of γ-butyrolactone for 5 minutes, the coating was washed using methanol as a rinse solution, and the solvent was removed under the air flow until the mass did not change any more. The mass of the film remaining on the silicon wafer after removal of the solvent was defined as the mass of the exposed portion after development, and the exposed portion residual film ratio was determined by the following formula.

$$\text{Exposed portion residual film ratio (\%)} = [\text{mass of exposed portion after development/mass of exposed portion before development}] \times 100$$

The equipment and conditions used during the development in the (2) and (3) above were as follows.

UV irradiation equipment: ECS-1511 U (available from Eye Graphics Co., Ltd.)
Light Source: High pressure mercury lamp
Illuminance: 670 to 700 mW/$cm^2$
Cumulative dose: 2400 mJ/$cm^2$
Developer: γ-Butyrolactone
Development Time: 5 minutes
Rinse solution: methanol
Silicon wafer: 4 inch silicon wafer (available from Advantec Co., Ltd.)

Synthesis Example 1

97.279 g (0.28 mol) of 1,4-bis[2-(4-aminophenyl)-2-propyl]benzene (hereinafter, BiS-AP), 32.141 g (0.12 mol)

of 1-(4-aminophenyl)-2,3-dihydro-1,3,3-trimethyl-1H-inden-5-amine (hereinafter, TMDA), 18.754 g (0.19 mol) of triethylamine (hereinafter, TEA), 0.083 g (0.74 mmol) of triethylenediamine (hereinafter, TEDA), and 259.7g of γ-butyrolactone (hereinafter, GBL) were charged under nitrogen into a 500 ml five-necked flask equipped with a nitrogen introduction tube, a stirrer, a thermometer, and a condenser, and heated to 70°C with stirring. Next, 82.943 g (0.37 mol) of 1,2,4,5-cyclohexantetracarboxylic dianhydride (hereinafter, HPMDA) was added, and reacted for 5 hours at 180°C. The mixture was diluted with 536.8 g of N,N-dimethylacetamide (hereinafter, DMAc) to form 995 g of a polyimide varnish having a solid content concentration of 20 mass%. As a result of measurement by GPC, the weight average molecular weight of the polyimide obtained in this synthesis example was 15800.

Synthesis Example 2

Except that the amount of BiS-AP was 93.921 g (0.27 mol), the amount of TMDA was 31.126 g (0.12 mol), the amount of TEA was 18.72 g (0.19 mol), the amount of TEDA was 0.083 g (0.74 mmol), the amount of GBL was 254.8 g, and the amount of DMAc was 524.3 g, preparation was carried out in the same manner as in synthesis example 1 and 973g of polyimide varnish was obtained. As a result of measurement by GPC, the weight average molecular weight of the polyimide obtained in this synthesis example was 27000.

Synthesis Example 3

Except that the amount of BiS-AP was 92.462 g (0.27 mol), the amount of TMDA was 30.642 g (0.12 mol), the amount of TEA was 18.72 g (0.19 mol), the amount of TEDA was 0.083g (0.74 mmol), the amount of GBL was 252.4 g, and the amount of DMAc was 519.3 g, preparation was carried out in the same manner as in synthesis example 1, and 964g of polyimide varnish was obtained. As a result of measurement by GPC, the weight average molecular weight of the polyimide obtained in this synthesis example was 33200.

Synthesis Example 4

Except that the amount of BiS-AP was 91.513 g (0.27 mol), the amount of TMDA was 30.327 g (0.11 mol), the amount of TEA was 18.72 g (0.19 mol), the amount of TEDA was 0.083 g (0.74 mmol), the amount of GBL was 250.9 g, and the amount of DMAc was 516.1 g, preparation was carried out in the same manner as in synthesis example 1 and 959g of polyimide varnish was obtained. As a result of measurement by GPC, the weight average molecular weight of the polyimide obtained in this synthesis example was 42800.

Synthesis Example 5

Except that the amount of BiS-AP was 90.401 g (0.26 mol), the amount of TMDA was 29.959 g (0.11 mol), the amount of TEA was 18.72 g (0.19 mol), the amount of TEDA was 0.083 g (0.74 mmol), the amount of GBL was 249.0 g, and the amount of DMAc was 512.3 g, preparation was carried out in the same manner as in synthesis example 1 and 952g of polyimide varnish was obtained. As a result of measurement by GPC, the weight average molecular weight of the polyimide obtained in this synthesis example was 75600.

Synthesis Example 6

Except that the amount of BiS-AP was 0.00 g (0.00 mol), the amount of TMDA was 103.720 g (0.39 mol), the amount of TEA was 1.871 g (0.018 mol), the amount of TEDA was 0.0 g (0.00 mmol), the amount of GBL was 228.3 g, and the amount of DMAc was 464.1 g, preparation was carried out in the same manner as in synthesis example 1 and 865g of polyimide varnish was obtained. As a result of measurement by GPC, the weight average molecular weight of the polyimide obtained in this synthesis example was 14000.

Synthesis Example 7

Except that the amount of BiS-AP was 0.00 g (0.00 mol), the amount of TMDA was 0.00 g (0.00 mol), 130.950 g (0.39 mol) of 4,4'-oxybis[3-(trifluoromethyl)benzenamine] (hereinafter, 6FODA) was added as an aromatic diamine, the amount of TEA was 1.871 g (0.018 mol), the amount of TEDA was 0.0 g (0.00 mmol), the amount of GBL was 261.6 g, and the amount of DMAc was 539.7 g, preparation was carried out in the same manner as in synthesis example 1 and 1002g of polyimide varnish was obtained. As a result of measurement by GPC, the weight average molecular weight of the polyimide obtained in this synthesis example was 23100.

Synthesis Example 8

Except that the amount of BiS-AP was 0.00 g (0.00 mol), the amount of TMDA was 31.13 g (0.12 mol), 93.92 g (0.27 mol) of 1,3-bis[2-(4-aminophenyl)-2-propyl] benzene (hereinafter BiS-AM) was added as an aromatic diamine, the amount of TEA was 21.248 g (0.21 mol), the amount of TEDA was 0.094 g (0.83 mmol), the amount of GBL was 254.6 g, and the amount of DMAc was 525.4 g, preparation was carried out in the same manner as in synthesis example 1 and 975g of polyimide varnish was obtained. As a result of measurement by GPC, the weight average molecular weight of the polyimide obtained in this synthesis example was 28100.

The average molecular weight of the polyimide resin obtained in Synthesis Example 1 to 8 is summarized in Table 1.

[Table 1]

Table 1

| | Synthesis Examples | | | | | | | |
|---|---|---|---|---|---|---|---|---|
| | 1 | 2 | 3 | 4 | 5 | 6 | 7 | 8 |
| Number average molecular weight [Mn] | 9400 | 15100 | 18400 | 15700 | 36100 | 7000 | 10600 | 17000 |
| Weight average molecular weight | 15800 | 27000 | 33200 | 42800 | 75600 | 14000 | 23100 | 28100 |

Example 1

160 g of the polyimide varnish prepared in Synthesis Example 1, 4.95 g of 2-isocyanatoethyl acrylate (Karenz AOI, available from Showa Denko), and 0.05 g of paramethoxy phenol (hereinafter, MEHQ) were placed and reacted for five hours at 50°C. Thereafter, the reaction liquid was dropped into water, and the polyimide was deposited, dried overnight at 70°C, and a polyimide resin (A) was obtained. 3 g of this polyimide resin (A) was dissolved in 10g of GBL, and 0.75 g of trimethylolpropane triacrylate (TMP-TA), 0.045 g of 1-hydroxycyclohexylphenylketone (IRGACURE184, available from BASF), and 0.105 g of bis(2,4,6-trimethylbenzoyl)phenylphosphine oxide (IRGACURE819, available from BASF) were added and stirred until dissolved to form a photosensitive resin composition (photosensitive resin varnish). The photosensitive resin composition was applied to a silicon wafer and dried at 100°C for 60 minutes. The coating was immersed in GBL for 5 minutes, rinsed with methanol, and the solvent was removed until there was no change in mass under air flow, and the unexposed portion residual film ratio was calculated. The unexposed portion residual film ratio at this time was 0%. Furthermore, after the photosensitive resin composition was applied to a silicon wafer and dried for 60 minutes at 100°C, Eye Mini Grantage (ECS-1511U) available from Eye Graphics Co., Ltd. was used and a high-pressure mercury lamp was employed as the light source, the cured film was formed by exposure under conditions of a dose of 1500 to 2500 $mJ/cm^2$ at an exposure wavelength of 365 nm, and then immersed for 5 minutes in a GBL, rinsed with methanol, and the solvent was removed under air flow until there was no mass change, and the exposed portion residual film ratio was calculated.

The exposed portion residual film ratio at this time was 100%. The results are shown in Table 2.

Examples 2 to 9 and Comparative Example 1

A photosensitive resin composition was prepared in the same manner as in Example 1 with the exception that the formulations shown in the following table were used, and the properties thereof were evaluated. The results are shown in Table 2.

[Table 2]

Table 2

| | Unit | Example | | | | | | | | | Comparative Example |
|---|---|---|---|---|---|---|---|---|---|---|---|
| | | 1 | 2 | 3 | 4 | 5 | 6 | 7 | 8 | 9 | 1 |
| Raw material polyimide (terminal unmodified) | | Synthesis Example 1 | Synthesis Example 2 | Synthesis Example 2 | Synthesis Example 3 | Synthesis Example 4 | Synthesis Example 6 | Synthesis Example 7 | Synthesis Example 7 | Synthesis Example 8 | Synthesis Example 5 |
| Mw | | 15800 | 27000 | 27000 | 33200 | 42800 | 14000 | 23100 | 23100 | 28100 | 75600 |
| Photosensitive group introduction (terminal modification) | | | | | | | | | | | |
| Polyimide | g | 160 | 150 | 180 | 150 | 180 | 181 | 182 | 180 | 175 | 180 |
| AOI | g | 4.95 | 3.30 | | 2.35 | 3.25 | | | | 3.21 | 1.37 |
| BEI*1 | g | | | 6.00 | | | 7.65 | 7.26 | 2.24 | | |
| MEHQ | g | 0.05 | 0.03 | 0.06 | 0.02 | 0.03 | 0.07 | 0.08 | 0.02 | | 0.01 |
| Cured Film Evaluation | | | | | | | | | | | |
| Terminal-modified polyimide resin | g | 3.0 | 3.0 | 3.0 | 3.0 | 3.0 | 4.9 | 4.7 | 4.6 | 3.0 | 3.0 |
| GBL | g | 10.0 | 10.0 | 10.0 | 10.0 | 10.0 | 11.6 | 7.1 | 5.6 | 4.5 | 10.0 |
| TMP-TA | g | 0.75 | 0.75 | | 0.75 | 0.75 | | | | | 0.75 |
| diPE-HA*2 | g | | | 0.75 | | | 1.27 | 1.20 | 1.19 | 0.76 | |
| IRGACURE 184 | g | 0.045 | 0.045 | 0.045 | 0.045 | 0.045 | 0.077 | 0.075 | 0.068 | 0.045 | 0.045 |
| IRGACURE 819 | g | 0.105 | 0.105 | 0.105 | 0.105 | 0.105 | 0.172 | 0.167 | 0.159 | 0.110 | 0.105 |
| Unexposed Portion Residual Film Ratio | % | 0 | 0 | 0 | 7 | 5 | 0 | 0 | 0 | 0 | 52 |

(continued)

| | Unit | Example | | | | | | | | | Comparative Example |
|---|---|---|---|---|---|---|---|---|---|---|---|
| | | 1 | 2 | 3 | 4 | 5 | 6 | 7 | 8 | 9 | 1 |
| Exposed Portion Residual Film Ratio | % | 100 | 100 | 100 | 100 | 100 | 100 | 100 | 99 | 100 | 100 |

* 1: 1,1-bis(acryloyloxymethyl)ethyl isocyanate (Karenz BEI, available from Showa Denko K.K.)

* 2: Dipentaerythritol hexaacrylate

Compared to comparative example 1, it is clear that the cured film containing the photosensitive resin composition according to the present embodiment had excellent developing properties. It was also confirmed that the cured film containing the photosensitive resin composition according to the present embodiment did not crack.

## Claims

1. A photosensitive resin composition comprising a polyimide resin (A) having a structure represented by General Formula (1) and having a weight average molecular weight of 70000 or less,

[Chem 1]

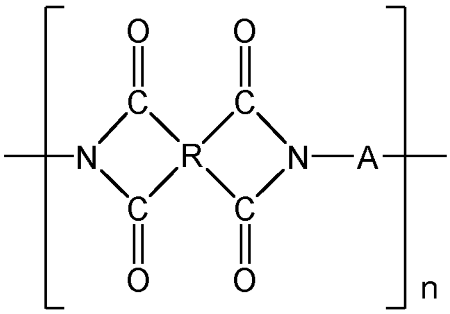

(1)

where R is a tetravalent group having 4 to 10 carbons and having a cyclic structure, an acyclic structure, or a cyclic structure and an acyclic structure, A has at least one group selected from the group consisting of an aliphatic hydrocarbon group, cycloaliphatic hydrocarbon group, aromatic hydrocarbon group, and organosiloxane group, and is a divalent group having from 2 to 39 carbons, on a main chain of A, at least one intervening group selected from the group consisting of -O-,$-SO_2-$,-CO-,$-CH_2-$,$-C(CH_3)_2-$,$-C_2H_4O-$, and -S- may be present, n indicates the number of repeating units, a terminal end of General Formula (1) is either a group represented by Formula (2) or Formula (3) or a hydrogen atom, and at least one of the terminal ends is a group represented by Formula (2) or Formula (3);

[Chem 2]

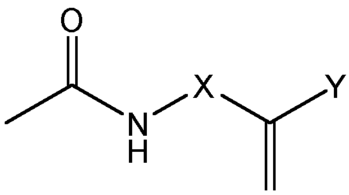

(2)

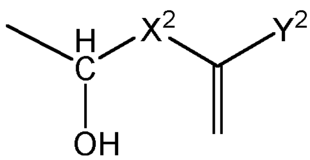

(3)

where X and $X^2$ are each independently a group having from 2 to 15 carbons and may have at least one group selected from the group consisting of ester bonds and double bonds, and Y and $Y^2$ are each independently a hydrogen atom or a methyl group.

2. The photosensitive resin composition according to claim 1, wherein a weight average molecular weight of the polyimide resin (A) is 5000 or greater.

3. The photosensitive resin composition according to claim 1 or 2, wherein a light transmittance at a wavelength from 200 to 400 nm of the photosensitive polyimide resin (A) is 50% or greater.

4. The photosensitive resin composition according to any one of claims 1 to 3, wherein a residual film ratio of an

unexposed portion after exposure under a condition of a dose from 1500 to 2500 m $J/cm^2$ at a wavelength of 365 nm is 40% or less.

**5.** The photosensitive resin composition according to any one of claims 1 to 4, wherein A in General Formula (1) comprises an aromatic ring as the aromatic hydrocarbon group.

**6.** The photosensitive resin composition according to any one of claims 1 to 5, wherein A in General Formula (1) comprises at least one type selected from the group consisting of the structures shown below;

[Chem 3]

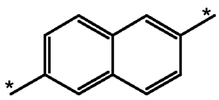
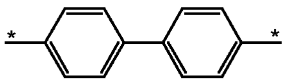
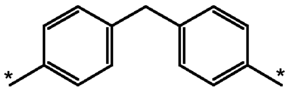
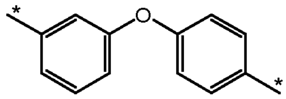
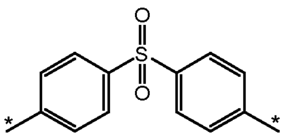
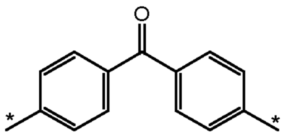
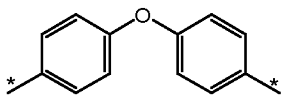
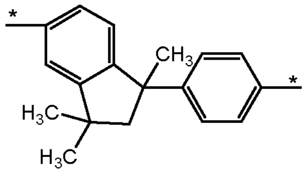
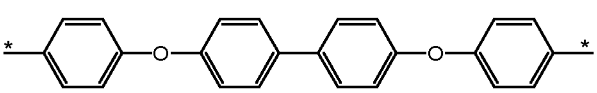
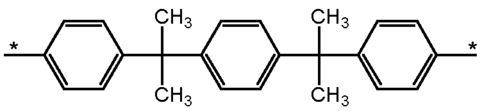
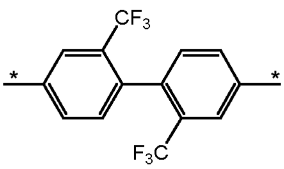
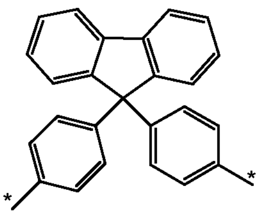
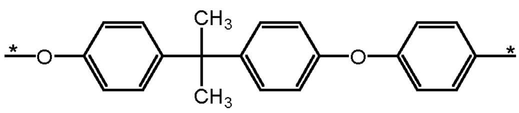
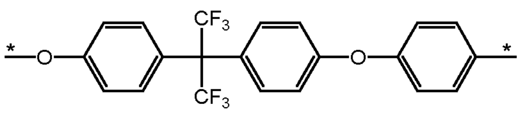
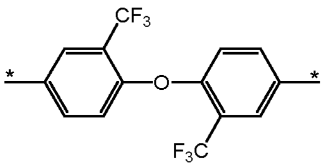
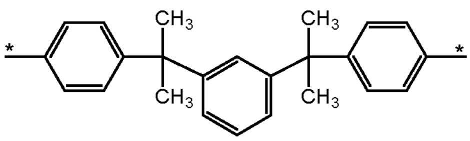

where * indicates an atomic bond.

**7.** The photosensitive resin composition according to any one of claims 1 to 6, wherein the polyimide resin (A) includes at least one type of units constituted of 4,4'-diamino-2,2'-bis(trifluoromethyl)biphenyl, 1-(4-aminophenyl)-2,3-dihydro-1,3,3-trimethyl-1H-indene-5-amine, 4,4'-oxybis[3-(trifluoromethyl)benzenamine] or 1,3-bis[2-(4-aminophenyl)-2-propyl]benzene.

**8.** The photosensitive resin composition according to any one of claims 1 to 7, further comprising at least one selected from the group consisting of a photopolymerization initiator, a solvent, and a photopolymerizable compound.

**9.** The photosensitive resin composition according to claim 8, wherein the photopolymerizable compound is a polyfunctional radical polymerizable monomer.

**10.** The photosensitive resin composition according to any one of claims 1 to 9, further comprising a sensitizer.

**11.** The photosensitive resin composition according to any one of claims 1 to 10, which is used for forming an insulating film.

**12.** A cured film formed by curing the photosensitive resin composition according to any one of claims 1 to 11.

**13.** The cured film according to claim 12, wherein a thickness of the film is from 10 to 85 μm.

**INTERNATIONAL SEARCH REPORT**

International application No. PCT/JP2020/021023

A. CLASSIFICATION OF SUBJECT MATTER
C08G 73/12(2006.01)i; G03F 7/027(2006.01)i; G03F 7/20(2006.01)i
FI: G03F7/027 514; G03F7/20 521; C08G73/12

According to International Patent Classification (IPC) or to both national classification and IPC

B. FIELDS SEARCHED

Minimum documentation searched (classification system followed by classification symbols)
C08G73/12; G03F7/027; G03F7/20

Documentation searched other than minimum documentation to the extent that such documents are included in the fields searched

| | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2017-513959 A (FUJIFILM ELECTRONIC MATERIALS U.S.A., INC.) 01.06.2017 (2017-06-01) claims, synthesis examples, mixture examples, paragraph [0160] | 1-9, 11-13<br>10 |
| X<br>A | WO 2018/181311 A1 (TORAY INDUSTRIES, INC.) 04.10.2018 (2018-10-04) claims, synthesis example 5, examples 82-83, paragraphs [0353], [0425] | 1-6, 8-13<br>7 |
| X<br>Y<br>A | JP 2011-180571 A (ETERNAL CHEMICAL CO., LTD.) 15.09.2011 (2011-09-15) claims, examples 5-7 | 1-6, 8-9, 11-13<br>10<br>7 |
| A | WO 2017/022465 A1 (FUJIFILM CORPORATION) 09.02.2017 (2017-02-09) claims, examples | 1-13 |
| A | JP 2018-517168 A (FUJIFILM ELECTRONIC MATERIALS U.S.A., INC.) 28.06.2018 (2018-06-28) claims, examples | 1-13 |

☐ Further documents are listed in the continuation of Box C.    ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 07 August 2020 (07.08.2020) | 25 August 2020 (25.08.2020) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**
Information on patent family members

International application No.
PCT/JP2020/021023

| Patent Documents referred in the Report | Publication Date | Patent Family | Publication Date |
|---|---|---|---|
| JP 2017-513959 A | 01 Jun. 2017 | US 2015/0219990 A1<br>claims, examples,<br>paragraph [0117]<br>TW 201538574 A<br>KR 10-2016-0114085 A<br>CN 106164132 A | |
| WO 2018/181311 A1 | 04 Oct. 2018 | CN 110392864 A<br>KR 10-2019-0130123 A<br>TW 201841059 A | |
| JP 2011-180571 A | 15 Sep. 2011 | US 2011/0212402 A1<br>claims, examples 5-7<br>TW 201131290 A | |
| WO 2017/022465 A1 | 09 Feb. 2017 | US 2018/0154671 A1<br>claims, examples<br>EP 3330097 A1<br>CN 107921808 A | |
| JP 2018-517168 A | 28 Jun. 2018 | US 2016/0313641 A1<br>claims, examples<br>TW 201704343 A<br>KR 10-2018-0022644 A<br>CN 108027564 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2013076845 A
- WO 2018003725 A
- JP 2000147761 A